Europäisches Patentamt

European Patent Office

Office européen des brevets

Veröffentlichungsnummer: **0 300 261**
**A1**

# EUROPÄISCHE PATENTANMELDUNG

Anmeldenummer: 88110671.0

Anmeldetag: 04.07.88

Int. Cl.⁴: **H03K 17/74 , H03K 17/76**

Priorität: 17.07.87 DE 3723738

Veröffentlichungstag der Anmeldung:
25.01.89 Patentblatt 89/04

Benannte Vertragsstaaten:
**DE FR GB NL**

Anmelder: **Siemens Aktiengesellschaft Berlin und München**
**Wittelsbacherplatz 2**
**D-8000 München 2(DE)**

Erfinder: **Kess, Helmut**
**Spardorfer Strasse 5**
**D-8520 Erlangen(DE)**

### PIN-Dioden-Schalter.

Bei herkömmlichen Schaltern ist die Amplitude einer zu schaltenden Hochfrequenzspannung durch die zur Verfügung stehende Sperr-Vorspannung begrenzt. Zur Erzeugung hoher Sperr-Vorspannungen ist ein Hochspannungsnetzteil erforderlich, das für viele Anwendungsfälle hohe Schaltgeschwindigkeiten aufweisen muß. Die Realisierung eines schnell schaltenden Hochspannungsnetzteiles ist jedoch aufwendig. Ein PIN-Dioden-Schalter soll daher so ausgeführt werden, daß keine Sperr-Vorspannung benötigt wird.

Diese Aufgabe wird dadurch gelöst, daß eine Reihenschaltung zweier entgegengesetzt gepolter PIN-Dioden (1,2) vorgesehen ist, wobei ein Steuerstrom ($I_{v1}$) der Verbindungsstelle der beiden PIN-Dioden (1,2) über die Reihenschaltung eines Transistors (11, 14) und einer Drossel zugeführt wird.

Dieser PIN-Dioden-Schalter kann vorteilhaft zum Schalten von Hochfrequenzspannungen eingesetzt werden.

FIG 5

EP 0 300 261 A1

## PIN-Dioden-Schalter

Die Erfindung betrifft einen PIN-Dioden-Schalter für Hochfrequenzspannungen mit einer zwischen seinem Eingang und seinem Ausgang angeordneten Reihenschaltung einer ersten und zweiten, zur ersten entgegengesetzt gepolten PIN-Diode, wobei ein Steuerstrom der Verbindungsstelle der beiden PIN-Dioden zugeführt wird.

Ein derartiger PIN-Dioden-Schalter ist aus der Literaturstelle "E.D.N. Electrical Design News", Band 27, Nr. 18, 15. Sept. 1982, Seiten 161-166 bekannt. Die dort beschriebene Ansteuerschaltung ist nur für kleine Hochfrequenzspannungen geeignet. Bei höheren Hochfrequenzspannungen würde man eine entsprechend hohe Sperrvorspannung benötigen.

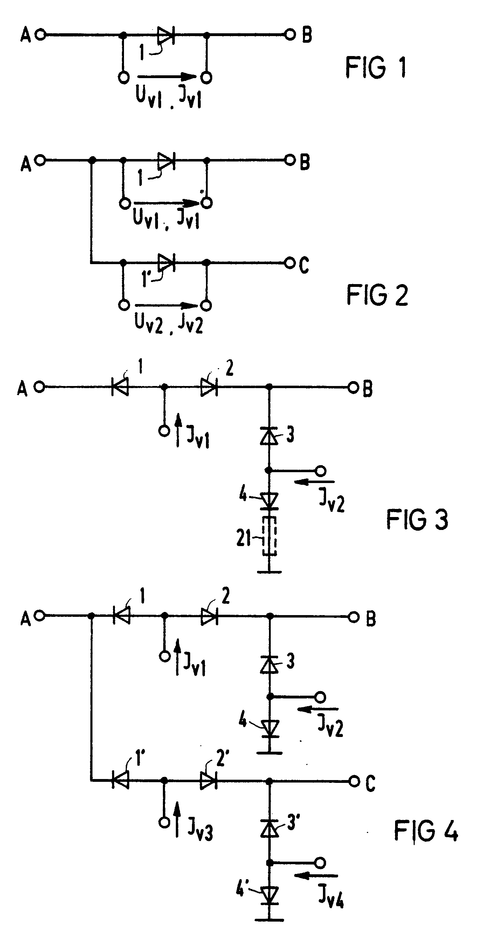

Die Anwendung von PIN-Dioden für HF-Schalter ist beispielsweise aus dem Buch G.Kesel et al "Signalverarbeitende Dioden", Berlin 1982, Seiten 54-56, bekannt. Zur Erläuterung der Problemstellung wird das bekannte Schaltprinzip anhand der FIG 1 erläutert.

Zwischen einem Eingang A und einem Ausgang B ist eine PIN-Diode 1 angeordnet. An die PIN-Diode wird ein Steuerstrom $I_{v1}$ bzw. eine Steuerspannung $U_{v1}$ angelegt. Die PIN-Diode 1 ist in leitendem Zustand, solange sie nicht mit einer Steuerspannung $U_{v1}$ in Sperrichtung als Sperr-Vorspannung beaufschlagt wird.

Entsprechend FIG 2 können PIN-Dioden auch als Umschalter Verwendung finden, indem eine weitere PIN-Diode 1' vorgesehen ist, die den Eingang A mit einem zweiten Ausgang C verbindet. Die PIN-Dioden 1, 1' können z.B. wechselweise mit Sperrspannung beaufschlagt werden.

Bei diesem herkömmlichen Schaltungsprinzip ist die zu schaltende Hochfrequenzspannung in ihrer Amplitude durch die zur Verfügung stehende Sperr-Vorspannung $U_{v1}$ begrenzt, die wiederum nicht höher als die maximal zulässige Sperrspannung der PIN-Dioden 1 bzw. 1' werden darf. Zur Erzeugung hoher Sperr-Vorspannungen ist also ein schaltendes Hochspannungsnetzteil erforderlich, dessen Realisierung verhältnismäßig aufwendig ist.

Aufgabe der Erfindung ist es daher, einen PIN-Dioden-Schalter so auszuführen, daß keine Sperr-Vorspannung benötigt wird.

Diese Aufgabe wird erfindungsgemäß dadurch gelöst, daß der Steuerstrom über die Reihenschaltung der Kollektor-Emitter-Strecke eines Transistors und einer Drossel in den Verbindungspunkt beider PIN-Dioden eingespeist wird.

Durch die beiden entgegengesetzt gepolten PIN-Dioden und die besondere Art der Ansteuerschaltung entfällt die Notwendigkeit einer Sperr-Vorspannung. Wenn die Transistoren nicht eingeschaltet sind, wirken diese lediglich als Kondensatoren kleiner Kapazität, die nur einmal über die PIN-Dioden aufgeladen werden. Dadurch ist keine Sperr-Vorspannung notwendig. Zum Schalten in den leitenden Zustand wird der PIN-Dioden-Schalter mit einem Steuerstrom beaufschlagt. Ein zu schaltender Steuerstrom bei niedriger Spannung ist jedoch wesentlich leichter zu realisieren als eine zu schaltende Hochspannung, insbesondere wenn ein schneller Schaltvorgang erforderlich ist.

Die aufgrund des endlichen Sperrwiderstandes des PIN-Dioden-Schalters noch übertragenen Ströme können gegen Bezugspotential abgeleitet werden bzw. werden reflektiert, wenn der Ausgang des PIN-Dioden-Schalters über eine zweite Reihenschaltung einer dritten und einer vierten, zur dritten entgegengesetzt gepolten Diode mit Bezugspotential verbunden ist und wobei der Verbindungspunkt der dritten und vierten PIN-Dioden ebenfalls mit einem Steuerstrom beaufschlagbar ist. Zwischen der vierten PIN-Diode und Bezugspotential kann ein Widerstand eingefügt sein. Damit wird ein reflexionsfreier Abschluß bewirkt.

Weitere vorteilhafte Ausgestaltungen der Erfindung sind in den Unteransprüchen 4 und 5 angegeben.

Das Prinzip der Erfindung wird nachfolgend anhand der FIG 3 näher erläutert. Zwischen einem Eingang A und einem Ausgang B ist eine erste Reihenschaltung zweier entgegengesetzt gepolter PIN-Dioden 1 und 2 angeordnet. Der Ausgang B ist über eine zweite Reihenschaltung zweier ebenfalls entgegengesetzt gepolter PIN-Dioden 3 und 4 mit Bezugspotential verbunden. In den Verbindungspunkt der ersten und zweiten PIN-Diode 1 und 2 und den Verbindungspunkt der dritten und vierten PIN-Diode 3 und 4 sind jeweils Steuerströme $I_{v1}$ bzw. $I_{v2}$ einspeisbar. Wenn der dargestellte PIN-Dioden-Schalter geschlossen, d.h. eine Verbindung zwischen Eingang A und Ausgang B hergestellt werden soll, wird in den Verbindungspunkt der ersten PIN-Diode 1 mit der zweiten PIN-Diode 2 ein Steuerstrom $I_{v1}$ eingespeist, der für beide PIN-Dioden 1 und 2 in Leitrichtung liegt. Damit werden beide PIN-Dioden 1 und 2 für ein am Eingang A eingespeistes Signal leitend, so daß eine leitende Verbindung zwischen Eingang A und Ausgang B besteht. Die zweite Reihenschaltung mit den PIN-Dioden 3,4 wird nicht mit Steuerstrom beaufschlagt und ist somit hochohmig, da immer eine der beiden PIN-Dioden 3,4 in Sperrichtung liegt.

Soll dagegen der dargestellte PIN-Dioden-Schalter sperren, so wird nur die zweite Reihenschaltung mit einem Steuerstrom $I_{v2}$ beaufschlagt, der wiederum für beide Dioden 3 und 4 in Leitrichtung liegt. Damit sperrt die erste Reihenschaltung, da stets eine der beiden PIN-Dioden 1 oder 2 in Sperrichtung liegt. Der dabei auftretende Sperrwiderstand nimmt selbstverständlich nur begrenzte Werte an. Ströme, die über die PIN-Dioden 1 und 2 noch übertragen werden, werden jedoch durch die leitende zweite Reihenschaltung kurzgeschlossen. Hochfrequenzsignale werden damit reflektiert. Falls eine Reflexion unerwünscht ist, kann die Verbindung zum Bezugspotential über einen (gestrichelt eingezeichneten) Widerstand 21 erfolgen, der die übertragene Hochfrequenzleistung absorbiert.

Die dargestellte Anordnung läßt sich, wie in FIG dargestellt, auch als Umschalter einsetzen, indem mit dem Eingang A zwei gleichartige PIN-Dioden-Schalter verbunden werden. Die mit den Elementen des ersten PIN-Dioden-Schalters übereinstimmenden Elemente des zweiten PIN-Dioden-Schalters weisen übereinstimmende Bezugszeichen auf, die lediglich durch einen Strich gekennzeichnet sind. Der zweite PIN-Dioden-Schalter ist mit einem Ausgang C verbunden.

Wenn das am Eingang A anstehende Signal zum Ausgang B übertragen werden soll, so wird im ersten PIN-Dioden-Schalter die Reihenschalter der PIN-Dioden 1 und 2 mit einem Steuerstrom $I_{v1}$ beaufschlagt und im zweiten PIN-Dioden-Schalter die Reihenschaltung der PIN-Dioden $3'$,$4'$ mit einem Steuerstrom $I_{v4}$ beaufschlagt. Damit wird die Verbindung zwischen Eingang A und Ausgang B leitend, während die Verbindung zum Ausgang C gesperrt ist.

Soll dagegen das am Eingang A anstehende Signal auf den Ausgang C durchgeschaltet werden, so werden im ersten PIN-Dioden-Schalter die PIN-Dioden 3 und 4 mit einem Steuerstrom $I_{v2}$ und im zweiten PIN-Dioden-Schalter die PIN-Dioden $1'$ und $2'$ mit einem Steuerstrom $I_{v3}$ beaufschlagt, während die verbleibenden Dioden nicht angesteuert werden. Damit besteht eine leitende Verbindung zwischen Eingang A und Ausgang C, während die Verbindung zum Ausgang B unterbrochen ist.

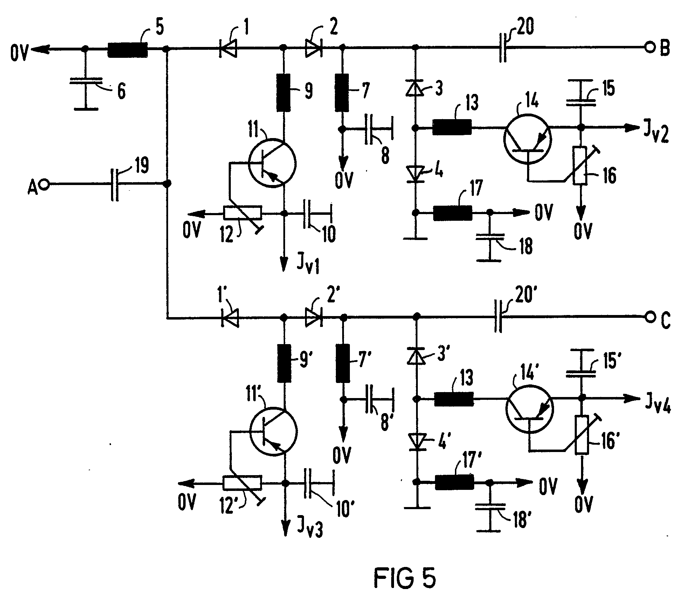

FIG 5 zeigt eine ausgeführte Schaltung mit einer Trennung zwischen den Gleichstrom-Ansteuerkreisen und dem Hochfrequenz-Kreis. Dabei ist die erste Reihenschaltung mit den PIN-Dioden 1 und 2 über einen Kondensator 19 mit dem Eingang A und über einen Kondensator 20 mit dem Ausgang B verbunden. Der Steuerstrom $I_{v1}$ für die erste Reihenschaltung wird dem Verbindungspunkt der PIN-Dioden 1,2 über die Kollektor-Emitter-Strecke eines Transistors 11 und eine Drossel 9 zugeführt. Die Basis-Vorspannung des Transistors 11 ist über ein Potentiometer 12 einstellbar, dessen beide Enden mit dem Emitter des Transistors 11 bzw. mit einem Nullpotential verbunden sind und an dessen Abgriff die Basis des Transistors 11 angeschlossen ist. Der Emitter des Transistors 11 ist ferner über einen Kondensator 10 mit Bezugspotential verbunden. Der über den Transistor 11 und die Drossel 9 zugeführte Steuerstrom fließt einerseits über die Diode 1 und eine Drossel 5 zum Nullpotential ab und andererseits über die zweite PIN-Diode und eine Drossel 7 ebenfalls zum Nullpotential. Die den PIN-Dioden 1,2 abgewandten Anschlüsse der Drosseln 5,7 werden über je einen Kondensator 6 bzw. 8 hochfrequenzmäßig an Masse gelegt.

Der Steuerstrom $I_{v2}$ für die zweite Reihenschaltung ist ebenfalls über einen Transistor 14 und eine Drossel 13 an den Verbindungspunkt der dritten und vierten PIN-Diode 3,4 angeschlossen. Dabei wird wieder die Basis-Vorspannung des Transistors 14 an einen Potentiometer 16 abgegriffen, das einerseits mit dem Emitter des Transistors 14 und andererseits mit Nullpotential verbunden ist. Der Emitter des Transistors 14 ist wiederum über einen Kondensator 15 an Masse gelegt. Der auf den Verbindungspunkt der PIN-Dioden 3,4 eingespeiste Steuerstrom fließt einerseits über die dritte PIN-Diode 3 und die Drossel 7 gegen Nullpotential und andererseits über die vierte PIN-Diode 4 zum Nullpotential ab. Der der vierten PIN-Diode 4 abgewandte Anschluß der Drossel 7 ist wiederum über einen Kondensator 18 an Masse gelegt.

Die Transistoren 11 und 14 sperren, solange sie nicht mit einem Steuerstrom beaufschlagt werden und entkoppeln damit den Ansteuerkreis vom PIN-Dioden-Schalter. Bei Beaufschlagung mit Steuerströmen $I_{v1}$ und $I_{v2}$ werden die Transistoren 11,14 leitend.

Die Anordnung nach FIG 5 weist noch einen zweiten Schaltungszweig auf, über den der Eingang A mit einem zweiten Ausgang C verbindbar ist. Diese Anordnung kann damit z.B. als Umschalter eingesetzt werden. Der zweite Schaltungszweig ist mit dem ersten identisch, gleiche Bauteile sind mit demselben Bezugszeichen versehen, das lediglich durch einen Strich gekennzeichnet ist. Die Drossel 5 und der Kondensator 6 werden für beide Schaltungszweige gemeinsam zur Ableitung des in die Dioden 1 und $1'$ eingespeisten Stromes verwendet.

Bei der dargestellten Schaltung sind die Gleichstrom-Steuerkreise für die erste Reihenschaltung durch die Drosseln 5,7 und 9 und die Gleichstrom-Steuerkreise der zweiten Reihenschaltung durch die Drosseln 7,13 und 17 von dem Hochfrequenz-führenden Stromkreis abgetrennt. Um eine Auskopplung der Hochfrequenz aus der Schaltungsanordnung zu verhindern, sind sämtliche abgehende Leitungen über die Kondensatoren 6,8,10,15 und 18 hochfrequenzmäßig gegen Masse kurzgeschlossen. Die Kondensatoren 19 und 20 verhindern, daß der in die PIN-Dioden 1 bis 4 eingespeiste Steuerstrom zum Eingang A bzw. zum Ausgang B übertragen wird.

Mit dem dargestellten PIN-Dioden-Schalter können auch Hochfrequenzspannungen mit hoher Amplitude angesteuert werden, ohne daß eine hohe Spannung für die Ansteuerung notwendig wäre. Die zulässige Amplitude der zu schaltenden Hochfrequenzspannung ist lediglich durch die Sperrspannung der PIN-Dioden 1 bis 4 begrenzt. Zur Ansteuerung ist nur ein Steuerstrom erforderlich, der - im Gegensatz zu hohen Sperr-Vorspannungen - leicht mit hohen Schaltfrequenzen und hohen Anstiegsgeschwindigkeiten erzeugt werden kann. >

**Ansprüche**

1. PIN-Dioden-Schalter für Hochfrequenzspannungen mit einer zwischen seinem Eingang (A) und seinem Ausgang (B,C) angeordneten Reihenschaltung einer ersten und einer zweiten, zur ersten entgegengesetzt gepolten PIN-Diode (1,2), wobei ein Steuerstrom ($I_{v1}$) der Verbindungsstelle der beiden PIN-Dioden (1,2) zugeführt wird, **dadurch gekennzeichnet,** daß der Steuerstrom ($I_{v1}$, $I_{v2}$) über die Reihenschaltung der Kollektor-Emitter-Strecke eines Transistors (11,14) und einer Drossel (9,13) in den Verbindungspunkt beider PIN-Dioden eingespeist wird.

2. PIN-Dioden-Schalter nach Anspruch 1, **dadurch gekennzeichnet,** daß der Ausgang (B,C) des PIN-Dioden-Schalters über eine zweite Reihenschaltung einer dritten und einer vierten, zur dritten entgegengesetzt gepolten Diode (3,4) mit Bezugspotential verbunden ist und daß der Verbindungspunkt der dritten und vierten PIN-Dioden (3,4) mit einem Steuerstrom ($I_{v2}$) beaufschlagbar ist.

3. PIN-Dioden-Schalter nach Anspruch 2,**dadurch gekennzeichnet,** daß zwischen der vierten PIN-Diode und Bezugspotential ein Widerstand (21) eingefügt ist.

4. PIN-Dioden-Schalter nach Anspruch 1 bis 3, **dadurch gekennzeichnet,** daß der Steuerstrom ($I_{v1}$, $I_{v2}$) über beide PIN-Dioden (1,2,3,4) und jeweils eine Drossel (5,7,17) abfließt und daß der Eingang (A) über einen Kondensator (19) mit dem Verbindungspunkt zwischen der ersten PIN-Diode (1) der ersten Reihenschaltung und der ersten Drossel (5) verbunden ist, wobei der Ausgang (B) über einen zweiten Kondensator (20) mit dem Verbindungspunkt der zweiten PIN-Diode (2) und der zweiten Drossel (7) verbunden ist und wobei einem Steueranschluß des Transistors (11,14) ein Steuersignal zugeführt wird.

5. PIN-Dioden-Schalter nach Anspruch 3, **dadurch gekennzeichnet,** daß der über die zweite PIN-Diode (2) und über die dritte PIN-Diode (3) fließende Steuerstrom über eine gemeinsame Drossel (7) abfließt.

A ○————————▷|————————○ B

$\overrightarrow{U_{v1} \cdot J_{v1}}$

1

**FIG 1**

A ○————————▷|————————○ B

$\overrightarrow{U_{v1} \cdot J_{v1}}$

1

————————▷|————————○ C

$\overrightarrow{U_{v2} \cdot J_{v2}}$

1'

**FIG 2**

A ○——◁|——————◁|————————○ B

1       2

$\uparrow J_{v1}$

3

$\leftarrow J_{v2}$

4

21

**FIG 3**

A ○——◁|——————◁|————————○ B

1       2

$\uparrow J_{v1}$

3

$\leftarrow J_{v2}$

4

——◁|——————◁|————————○ C

1'      2'

$\uparrow J_{v3}$

3'

$\leftarrow J_{v4}$

4'

**FIG 4**

FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | INSTRUM. & EXP. TECHN., Band 20, Nr. 1, Januar/Februar 1977, Seiten 125-127, Plenum Publishing Corp., New York, US; D. KOLLAR et al.: "Control circuits using diode switches" * Seite 125, Zeile 9 - Seite 126, Zeile 7; Figuren 1,2 * | 1,2 | H 03 K 17/74 H 03 K 17/76 |
| Y | Idem --- | 3,4,5 | |
| Y,D | E.D.N. ELECTRICAL DESIGN NEWS, Band 27, Nr. 18, 15. September 1982, Seiten 161-166, Boston, Massachusetts, US; J.L. HARTKE: "PIN-diode switches excel in wide-bandwidth use" * Seite 165; Figur 8(f) * --- | 4,5 | |
| Y | US-A-4 267 538 (ASSAL et al.) * Spalte 3, Zeile 54 - Spalte 4, Zeile 10; Figur 4 * --- | 3 | |
| Y | MOTOROLA SEMICONDUCTOR TECHNICAL INFORMATION, AN161, 6-65, Seiten 1-5; P.L. CLAR: "High power RF switching diode can replace mechanical coax relays" * Seite 3, linke Spalte, letzter Absatz; Figuren 1,4A * ----- | 4,5 | RECHERCHIERTE SACHGEBIETE (Int. Cl.4) H 03 K |

Der vorliegende Recherchenbericht wurde für alle Patentansprüche erstellt

| Recherchenort | Abschlußdatum der Recherche | Prüfer |
|---|---|---|
| DEN HAAG | 25-10-1988 | CANTARELLI R.J.H. |